# EUROPÄISCHE PATENTSCHRIFT

(11) **EP 4 217 121 B1**
(45) Veröffentlichungstag und Bekanntmachung des Hinweises auf die Patenterteilung: **29.07.2026**
(21) Anmeldenummer: 21785856.2
(22) Anmeldetag: 28.09.2021
(51) Int. Cl.: B06B 1/06, H10N 30/85

(54) **ERREGUNGSELEMENT**
EXCITATION ELEMENT
ÉLÉMENT D'EXCITATION

(30) Priorität: 28.09.2020 EP 20198602
(43) Veröffentlichungstag der Anmeldung: 02.08.2023
(73) Patentinhaber: Spektra Schwingungstechnik und Akustik GmbH Dresden, 01189 Dresden (DE)
(72) Erfinder: IWANCZIK, Martin, 01219 Dresden (DE); MENDE, Michael, 01189 Dresden (DE)
(74) Vertreter: Lippert Stachow Patentanwälte Rechtsanwälte Partnerschaft mbB
(86) Internationale Anmeldenummer: PCT/EP2021/076615
(87) Internationale Veröffentlichungsnummer: WO 2022/064057

(56) Entgegenhaltungen:
- WO-A1-2016/110439
- WO-A1-2020/188866
- JP-A- H06 246 231
- US-A1- 2020 287 123
- ANONYMOUS: "Smart Material - Home of the MFC", 30 May 2017 (2017-05-30), XP055875989, Retrieved from the Internet <URL:https://web.archive.org/web/20170530224038/http://www.smart-material.com:80/MFC-product-main.html> [retrieved on 20220103]
- WANG ZIPING ET AL: "Design and optimization of an OPFC ultrasonic linear phased array transducer", INTERNATIONAL JOURNAL OF MECHANICS AND MATERIALS IN DESIGN, SPRINGER NETHERLANDS, DORDRECHT, vol. 13, no. 1, 2 July 2015 (2015-07-02), pages 57 - 69, XP036156121, ISSN: 1569-1713, [retrieved on 20150702], DOI: 10.1007/S10999-015-9317-Y

## Beschreibung

Die Erfindung betrifft ein Erregungselement zur Erzeugung von mechanischen Bewegungen mit einem Erreger und einer Aufnahme für ein zu testendes Objekt sowie mit einer elektrischen Schnittstelle zur Übermittlung der Erregungs- oder Messdaten.

Die Erfindung betrifft auch ein Verfahren zur Herstellung eines solchen Erregungselements.

Zur Funktionsprüfung, Charakterisierung oder Kalibrierung von Sensoren, insbesondere von Schwingungssensoren ist es bekannt, diese über einen Schwingungserreger, in eine kontrollierte determinierte Schwingung zu versetzen. Die Reaktion des Sensors, als dem Testobjekt oder Device Under Test (DUT) wird sodann gemessen und daraus Aussagen über die Funktionsfähigkeit gewonnen oder Werte zum Kalibrieren des Sensors abgeleitet.

Unter Kalibrieren wird dabei eine vergleichende Messung der Messgröße des DUT definiert, wobei die Messgröße des DUT auf ein nationales Normal rückgeführt wird**.** Dabei wird die Abweichung der Messgröße des DUT vom richtigen Wert der Messgröße festgestellt und dokumentiert.

Unter Funktionsprüfung oder Testen sollen Messungen verstanden werden, die während verschiedener Phasen des Produktes (Entwicklung, Verfizierung, Service) durchgeführt werden, um das Verhalten des DUT bezüglich seiner Messgröße über den Umfang einer Kalibrierung hinaus zu untersuchen.

Das Charakterisieren definiert Messungen, bei denen der DUT nicht nur mit seiner Messgröße angeregt, sondern bei denen auch das Verhalten des DUT auf Störeinflüsse, die während seines Lebenszyklus auftreten können, systematisch untersucht wird.

Für die Kalibrierung von Sensoren ist ein Schwingungserreger mit der Bezeichnung SE-09 der Anmelderin bekannt, welcher für Kalibrierungen im Frequenzbereich bis 20 kHz saubere translatorische Schwingungen erzeugen kann. Dort erfolgt die Schwingungserregung über einen rein elektrodynamischen Schwingungserreger, der über ein elektrodynamisches System, welches in einem Gehäuse angeordnet ist, angeregt wird. Eine Grundplatte stellt eine Gegenmasse des Schwingsystems dar. Das DUT wird auf dem Schwingungserreger befestigt. Nachteilig ist hierbei, dass die Schwingfrequenz mit 20 kHz nach oben hin begrenzt ist. Für die Funktionsprüfung und Charakterisierung von DUT kann der Schwingungserreger bis 50 kHz verwendet werden.

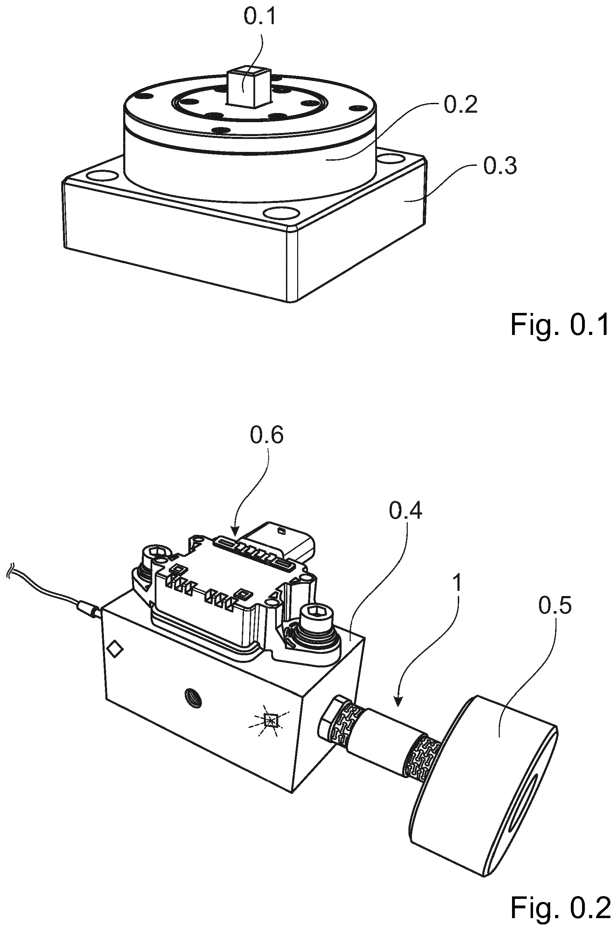

Ein Schwingungserreger ist mit der Bezeichnung SE-16 bekannt, welcher von der Anmelderin selbst angeboten wird. Dieser ist in Fig. 0.1 dargestellt. Dort erfolgt die Schwingungserregung über einen rein elektrodynamischen Schwingungserreger 0.1, der über ein elektrodynamisches System, welches in einem Gehäuse 0.2 angeordnet ist, angeregt wird. Eine Grundplatte 0.3 stellt eine Gegenmasse des Schwingsystems dar. Das DUT wird auf dem Schwingungserreger 0.1 befestigt. Nachteilig ist hierbei, dass die Schwingfrequenz prinzipbedingt mit 100 kHz nach oben hin begrenzt ist. Außerdem kann damit keine saubere translatorische Schwingung erzeugt werden.

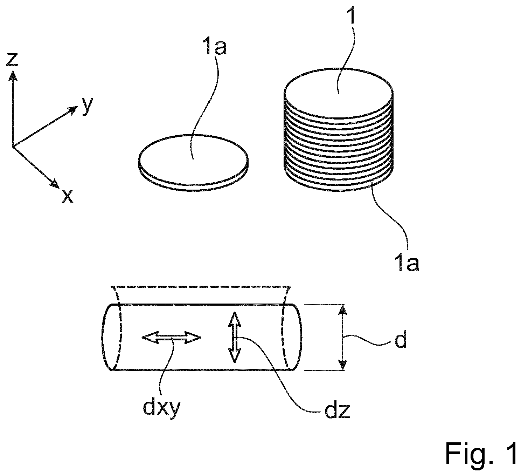

Es ist auch ein Schwingungsregelsystem der Anmelderin mit der Bezeichnung VCS 401-Piezo mit einem darin enthaltenen piezobasiertem Schwingungserreger bekannt, wie es in Fig. 0.2 dargestellt ist. In diesem kommt ein Piezoschwinger 1 zum Einsatz, wie er in Fig. 1 dargestellt ist. Der Piezoschwinger 1 ist zwischen dem Koppelkörper 0.4 und einer Gegenmasse 0.5 angeordnet. Der Schwinger 0.4 ist mit einer DUT-Aufnahme zur Aufnahme eines Prüfling 0.6 (Sensor) versehen. Die DUT-Aufnahme ist im Koppelkörper enthalten und besteht hier aus zwei M6-Innengewinden.

Das ist aber nur eine Variante der Ausführung. Damit besteht der Piezoschwinger aus dem Piezoantrieb und zwei schwingenden Massen und bildet damit einen freien Zweimassenschwinger. Eine der Massen kommt nur die Aufgabe einer Gegenmasse (0.5) zu, wobei der anderen Masse (0.4) die Funktion eines Koppelkörpers zukommt, an der ein DUT befestigt werden kann.

Dieser Piezoschwinger 1 wie auch am Markt erhältliche Piezoschwinger, wie z.B. der piezoelektrische Shaker von piezosystems Jena (100 kHz, 5 µm, 1000 N), siehe https://www.plezosystem.com/products/piezocomposite/products /shaker/, bestehen aus einem Stapel von einzelnen Piezoschwingplatten 1a mit einer quadratischen, rechteckigen oder runden (wie dargestellt) Grundfläche und einer Dicke d. Mit einem solchen Stapel von Piezoschwingplatten 1a kann eine gute translatorische Bewegung erreicht werden und es treten wenig in-plane-Moden auf. Jedoch lassen sich auch mit diesem Schwinger keine Schwingfrequenzen über 100 kHz erzeugen und im Datenblatt wird die obere Grenze mit 40 kHz angegeben. Auch hier kann oberhalb von 40 kHz zwar noch eine Schwingung erzeugt werden. Allerdings ist diese nicht mehr rein translatorisch und damit nicht mehr vollständig regelbar.

Mit einem zunehmenden Einsatz von Sensoren oder Aktoren in zahlreichen Anwendungsbereichen, der durch miniaturisierte Ausführungen, insbesondere in Mikrosystemen mit sogenannten MEMS (MicroElectromechanical System = MEMS) ermöglicht wird, besteht nunmehr die Notwendigkeit, MEMS-Sensoren zu testen, zu charakterisieren und/oder zu kalibrieren. Aber auch MEMS-Aktoren, also Bauteile, die aktiv Bewegungen erzeugen, müssen getestet, charakterisiert und kalibriert werden.

Die bekannten Schwingungserreger haben zum einen den Nachteil, dass selbst bei einer größtmöglichen Ausnutzung der physikalischen Grenzen der Frequenzbereich limitiert ist, so dass Messungen von MEMS bei höheren Frequenzen beispielsweise bei 100 kHz bis 3 MHz nicht möglich sind. Darüber hinaus ist eine Bewegung des DUT 3 nur in out-of-plane-Richtung 5 möglich. Eine Bewegung in in-plane-Richtung 10, d.h. bei der die Bewegungsachse 11 in horizontaler x-y-Richtung liegt, wie sie in den Figuren mit x-, y-, und z-Pfeilen dargestellt sind, als auch eine rotatorische Bewegung um diese Bewegungsachse ist nicht möglich. Zur eindeutigen Zuordnung wird die Bezeichnung "out-of-plane" für die z-Richtung und "in-plane" für die x-y-Richtung gewählt. Die Koordinatenachsen sind in den Zeichnungen angegeben.

Kommerziell sind Piezoplatten mit einer Nennfrequenz von 2 MHz und mehr verfügbar. Derartige Piezoschwinger werden z.B. von der Fa. PI Ceramic GmbH, 10 Lindenstraße, 07589 Lederhose, angeboten. Ein Problem ist dabei das Auftreten von in-plane Moden über den kompletten Frequenzbereich, die unkontrollierbare out-of-plane Bewegung erzeugen.

Einzelne Piezoschwingplatten 1a, wie in Fig. 1 dargestellt, haben den Nachteil, dass bei einer Längsanregung dz auch starke Queranregung dxy zu verzeichnen ist was zu unkontrollierter Bewegung der Platte führt. Wie bereits beschrieben, kann mit einem Stapel von Piezoschwingplatten 1a eine gute translatorische Bewegung erreicht werden und es treten wenig in-plane-Moden auf. Jedoch lassen sich auch mit diesem Schwinger keine Schwingfrequenzen oberhalb von einigen kHz bis zu einigen Megahertz erzeugen. Eine gleichmäßige Translation in "out-of-plane"-Richtung 5 ist nur in ausgewählten Frequenzbereichen möglich und "in-plane"-Bewegungen treten, wie oben beschrieben, auf, sind aber nicht kontrolliert anregbar, da sie nur als Nebeneffekt bzw. Koppeleffekt der Out-of-plane-Bewegung auftreten. Rotationen eines an dem Piezoschwinger befestigten DUT, oder Rotationen des DUT, sind gar nicht möglich.

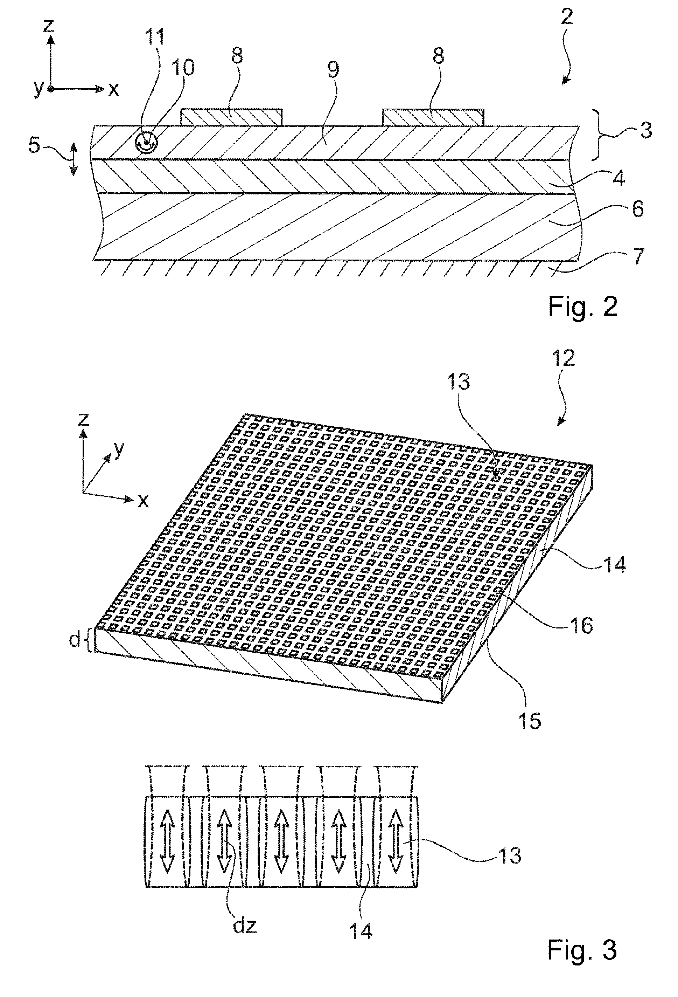

Aus der Akustik, insbesondere der akustischen Messtechnik sind akustische Signalgeneratoren in der Form von Komposit-Piezo 12 bekannt, wie ein solcher in Fig. 3 bis Fig. 5 dargestellt ist. Hierbei handelt es sich auch um eine Platte, wie zu Fig. 1 erläutert, allerdings ist diese in eine Vielzahl von n Piezoelementen 13 aufgeteilt. Die Piezoelemente 13 sind untereinander mittels einer Matrix 14 verbunden. Der Vorteil gegenüber einer Standard-Piezoplatte, wie sie in einem Piezoschwinger 1 zu sehen ist, besteht darin, dass sie eine deutlich geringer ausgeprägte Queranregung dxy zeigt. Eine Anwendung einer akustischen Schallquelle als Piezoschwinger 1 in einer Mess- oder Kalibrieranordnung 2 ist allerdings nicht bekannt.

Flexible Piezo-Verbundsensoren sind aus US2020287123 A1 bekannt.

Der Erfindung liegt nunmehr die Aufgabe zugrunde, ein Erregungselement zur Erzeugung oder Messung von mechanischen Bewegungen mit einem Erreger und einer Aufnahme für ein zu testendes Objekt sowie mit einer elektrischen Schnittstelle zur Übermittlung der Erregungs- oder Messdaten anzugeben, welches bei mechanischen Bewegungen in oberhalb von einem kHz, insbesondere oberhalb 40 kHz und bevorzugt oberhalb 100 kHz bis zu einer Größenordnung von mehreren 10 Megahertz zuverlässig arbeitet und sowohl "out-of-plane"-Bewegungen als auch Rotationen des DUT erlaubt.

Diese Aufgabe wird anordnungsseitig dadurch gelöst, dass eine an sich bekannte Piezoschwingplatte oder ein Piezoschwinger in Form eines Piezo-Komposits mit einer in Richtung der Plattendicke quer liegenden ersten Seite, einer mit der Plattendicke beabstandeten und parallel zur ersten Seite liegenden zweite Seite und mit sich zwischen erster und zweiter Seite erstreckenden stabförmigen Piezoelementen als Erreger verwendet wird. Der ist Erreger auf seiner ersten Seite mit einer ersten Kontaktfläche und auf seiner zweiten Seit mit einer zweiten Kontaktfläche versehen, wobei die Kontaktflächen ansteuerbar sind. Der Erreger ist auf seiner zweiten Seite ein zu testendes Objekt aufnehmend gestaltet, wobei der Erreger über der zweiten Kontaktfläche mit einer segmentierten Koppelplatte versehen ist.

Mit einer derartigen Anordnung wird es grundsätzlich überhaupt erst möglich, mechanischen Bewegungen in einem Frequenzbereich von oberhalb von einem kHz, insbesondere oberhalb 40 kHz und bevorzugt oberhalb 100 kHz bis zu einer Größenordnung von mehreren 10 Megahertz zuverlässig zu erzeugen.

Die Segmentierung der Koppelplatte dient der Abbildung der Partitionen des Erregers, d.h. die Segmentierung ist vorzugsweise so gewählt, dass die in einer Projektion in vertikaler z-Richtung gesehenen Schnittflächen der Kontaktstreifen der ersten und der zweiten Kontaktfläche die Partitionen bilden, die mit den Segmenten übereinstimmen, so dass Bewegungen der Segmente oder Bewegungen der Partitionen jeweils weitergeben werden können.

In einer Ausgestaltung der Erfindung ist vorgesehen, dass ein an sich bekannter plattenförmiger Komposit-Piezo mit einer in Richtung der Plattendicke quer liegenden ersten Seite, einer mit der Plattendicke beabstandeten und parallel zur ersten Seite liegenden zweiten Seite und mit sich zwischen erster und zweiter Seite erstreckenden stabförmigen Piezoelementen als Erreger verwendet wird und der Erreger in Segmente aus Piezoelementen gegliedert ist, die separat erregbar gestaltet sind.

Neben der deutlich geringer ausgeprägten Queranregung dxy ist auch eine insbesondere kundenspezifische Gestaltung von Partitionen möglich.

Zur Anregung einzelner Partitionen, zur gezielten Regelung einzelner Partitionen, zur Unterdrückung von Plattenmoden und/oder zur Rotationsanregung durch Phasenversatz zwischen Partitionen ist vorgesehen, dass der Erreger auf seiner ersten Seite mit einer ersten segmentierten Kontaktfläche und auf seiner zweiten Seite mit einer zweiten segmentierten Kontaktfläche versehen ist, wobei die Kontaktflächen über die Schnittstelle segmentweise und getrennt voneinander ansteuerbar sind. Der Erreger ist auf seiner zweiten Seite ein zu testendes Objekt aufnehmend gestaltet.

Zur Erzeugung der Partitionen ist vorgesehen, dass beide Kontaktflächen streifenförmig segmentiert sind, wobei jeder Kontaktstreifen die gleiche Breite aufweist.

Sollen streifenförmige Partitionen realisiert werden, können die Kontaktstreifen der beiden Kontaktflächen dieselbe Ausrichtung in horizontaler, d.h. in **x-** oder y-Richtung aufweisen.

Es ist aber auch möglich, inselförmige Partitionen dadurch zu erzeugen, dass die Kontaktstreifen auf der ersten Kontaktfläche eine Ausrichtung in einer ersten horizontalen, d.h**.** x-Richtung, und auf der zweiten Kontaktfläche in einer orthogonal zur ersten horizontalen zweiten Richtung, d.h. y-Richtung, liegenden Richtung aufweisen. Die in einer Projektion in vertikaler z-Richtung gesehenen Schnittflächen der Kontaktstreifen der ersten und der zweiten Kontaktfläche stellen dabei die inselförmigen Partitionen dar.

In einer Ausführungsform des Erregungselements ist vorgesehen, dass die Koppelplatte in streifenförmige erste Koppelplattensegmente segmentiert ist, derart, dass deren Breite und Richtung den Kontaktstreifen der zweiten Kontaktfläche entsprechen und die ersten Koppelplattensegmente in y-Richtung ausgerichtet sind und in vertikaler z-Richtung über den Kontaktstreifen der zweiten Kontaktfläche liegen. Somit werden streifenförmige Partitionen erzeugt. Diese können durch Anlegen einer Spannung an die jeweils einander in Z-Projektion gegenüberliegenden Kontaktstreifen einzeln angeregt werden. Somit sind alle translatorischen Bewegungen in Z-Richtung jeweils der einzelnen Partitionen getrennt voneinander möglich. Damit wird es möglich, Translationen des gesamten Erregungselements zu realisieren, wie aber auch wellenartige Bewegungen und dergleichen. Erstmals wird es aber auch möglich, durch eine um 180° phasenverschobene Ansteuerung voneinander benachbarter Partitionen oder einander benachbarter Gruppen von Partitionen Rotationen des DUT um eine Rotationsachse, die in der x-y-Richtung liegenden Ebene liegt, zu realisieren.

In einer weiteren Ausgestaltung des erfindungsgemäßen Erregerelements kann vorgesehen sein, dass die Koppelplatte unter Entstehung von quadratischen zweiten Koppelplattensegmenten zusätzlich in in x-Richtung verlaufende Streifen segmentiert ist, und die quadratischen zweiten Koppelplattensegmente bei einer Ausrichtung der Kontaktstreifen der ersten und der zweiten Kontaktfläche orthogonal zueinander in vertikaler z-Richtung über in einer in vertikaler z-Richtung gesehenen Schnittflächen der Kontaktstreifen der ersten und der zweiten Kontaktfläche liegen. Damit wird eine inselförmige Partitionierung erreicht. Einander in der Projektion kreuzende Kontaktstreifen können einzeln kontaktiert werden. Dabei werden die in den Schnittbereichen der jeweiligen Kontaktstreifen liegenden Piezoelemente bei Anlegen einer Spannung angeregt. Nach wie vor können aber auch ganze Steifen oder Gruppen wie oben beschrieben angeregt werden.

In einer bevorzugten Ausführung ist vorgesehen, dass die ersten oder zweiten Koppelplattensegmente jeweils benachbart miteinander mittels eines Verbindungsmittels mechanisch verbunden sind. Das Verbindungsmittel kann ausgeführt sein als:
- Schwächung der Struktur in diesem Bereich und einer damit verbundenen Verringerung der Steifigkeit
- Füllmaterial mit einem geringeren E-Modul als das Koppelplattensegment.

Damit können sich die Koppelplattensegmente zumindest im hier infrage kommenden Frequenzbereich unabhängig voneinander bewegen.

Das Verbindungsmittel kann aus Epoxydharz, Silikon oder einem anderen Kunststoff bestehen. Dies sind Materialien, die eine im Frequenzbereich liegende mechanische Entkopplung der Koppelplattensegmente realisieren.

Eine Aufgabe ist die mechanische Entkopplung. Eine andere Aufgabe, während der Fertigung einen ausreichend festen Halt zwischen den Koppelplattensegmenten zu erreichen.

Durch das Verbindungsmittel wird eine glatte Oberfläche der Koppelplatte realisiert, auf der das DUT aufgebracht, vorzugsweise aufgeklebt werden kann. Insbesondere leicht reversible Klebstoffe können hier zum Einsatz kommen, die vom DUT rückstands- und beschädigungsfrei entfernt werden können, um das DUT und auch den Erreger weiter einsetzen zu können.

Hier sei betont, dass es bei dem hier beschriebenen Erregungselement auf eine mechanische Kopplung zwischen DUT und Erregungselement ankommt, nicht auf eine akustische Kopplung, wie sie dem eigentlichen Verwendungszweck des Komposit-Piezo entspricht.

Um nicht nur eine bessere Verbindung des DUT mit der Koppelplatte zu gewährleisten, sondern auch ein Schwingsystem in Form eines freie Zweimassenschwingers zu realisieren, ist der Erreger an seiner ersten Kontaktfläche mit einer Gegenmasse verbunden. Dabei wirken die Koppelplattenelemente auf der einen Seite als eine Masse des Schwingsystems und die Gegenmasse auf der anderen Seite als zweite Masse des Schwingsystems.

Zur weiteren Ausgestaltung und Realisierung einzelner Zweimassenschwinger zu einem Zweimassenschwinger-Array ist vorgesehen, dass die Gegenmasse als Gegenmassenplatte ausgebildet ist, die korrespondierend zu der Koppelplatte in Gegenmassesegmente strukturiert ist, wobei die Dicke der Gegenmasseplatte von der Dicke der Koppelplatte abweichen kann. Es ist auch vorstellbar, dass auch an der ersten Seite noch DUT befestigt werden.

In einer weiteren Ausgestaltung ist vorgesehen, dass das Erregungselement auf einem zweiten Schwingungserreger befestigt ist. Dieser zweite Schwingungserreger kann beispielsweise ein elektrodynamischer Schwingungserreger sein, wie er aus dem Stand der Technik bekannt ist, beispielsweise ein SE-16 der Anmelderin. Damit wird es möglich, einen tiefen Frequenzbereich, in dem der zweite Schwingungserreger arbeiten kann, durch diesen abzudecken und höhere Frequenzen oberhalb des sicheren Arbeitsbereiches des zweiten Schwingungserregers mit dem erfindungsgemäßen Erregungselement.

Die erfindungsgemäße Aufgabenstellung wird auch durch ein Verfahren zur Herstellung eines Erregungselements gelöst. Dabei wird die Koppelplatte mit einem Abstand und einer Richtung, die denen der Koppelplattensegmente entsprechen, von ihrer zweiten- oder ersten Seite mit einem Einschnitt versehen. Dabei reicht der Einschnitt jedoch nicht bis zu der jeweiligen anderen zweiten oder ersten Seite sondern nur bis zu einem Abstand zu der gegenseitigen ersten oder zweiten Seite. Der Einschnitt wird dann mit dem Verbindungsmittel gefüllt. Zum Separieren der Koppelplattenelemente wird die Koppelplatte auf der jeweils gegenseitigen ersten oder zweiten Seite bis zum Erreichen des Einschnittes abgetragen.

Die Koppelplatte kann mit dem Erreger verbunden werden, beispielsweise durch Aufkleben. Dabei erfolgt die Verbindung so, dass einem Koppelplattensegment mehrere Erregerelemente, insbesondere ein oder mehrere Piezo-Segmente, gegenüberstehen. Somit sind die mehreren Erregerelemente für die Erregung des DUT im Bereich des Koppelplattenelements verantwortlich oder für die Detektion einer Aktion des DUT im Bereich des jeweiligen Koppelplattenelements.

Zur Erzeugung eines Schwingungssystems ist vorgesehen, dass der Erreger mit der Gegenmassenplatte verbunden und die Gegenmassenplatte in der Art der Koppelplatte strukturiert wird. Damit entstehen einzelne kleine Zweimassenschwinger in der Größe der Partitionen, die erfindungsgemäß einzeln ansteuerbar sind, so dass verschiedenste Bewegungsformen des DUT erzeugt werden können, wie translatorische Bewegungen und/oder rotatorische Bewegungen, insbesondere Kippbewegungen und/oder wellenförmige Bewegungen.

Insbesondere können auch rotatorische Bewegungen um eine in in-plane-Richtung liegende Rotationsachse erzeugt werden, wenn z.B. benachbarte Partitionen gegenläufig angesteuert werden.

Die Erfindung soll nachfolgend anhand eines Ausführungsbeispiels näher erläutert werden. In den Zeichnungen zeigt
- Fig. 0.1: einen Schwingungserreger SE-16 der Anmelderin,
- Fig. 0.2: ein piezobasierter Schwingungserreger als Teil des Schwingregelsystems VCS401-piezo der Anmelderin,
- Fig. 1: einen Standard-Piezoschwinger in verschiedenen Bauformen mit seinen Schwingungsverhalten,
- Fig. 2: einen erfindungsgemäßen prinzipiellen Aufbau einer Mess- oder Kalibrieranordnung,
- Fig. 3: eine perspektivische und eine Querschnittsdarstellung eines Piezo-Komposit,
- Fig. 4: einen vergrößerten Ausschnitt einer Perspektivdarstellung eines Piezo-Komposit,
- Fig. 5: einen Piezo-Komposit mit Kontaktstreifen,
- Fig. 6: eine perspektivische Darstellung eines Piezo-Komposit mit einem darauf angeordneten DUT,
- Fig. 7: einen Querschnitt durch das Piezo-Komposit aus Fig. 6 mit einem darauf angeordneten DUT und angelegter Spannung für eine translatorische Erregung,
- Fig. 8: einen Querschnitt durch das Piezo-Komposit aus Fig. 6 mit einem darauf angeordneten DUT und angelegter Spannung für eine rotatorische Erregung,
- Fig. 9: eine perspektivische Darstellung eines Piezo-Komposit mit einer streifenförmigen Koppelplatte und einem auf deren zweiten Seite angeordneten DUT,
- Fig. 10: Seitenansicht eines mit Kontaktstreifen auf der ersten Seite in y-Richtung und mit Kontaktstreifen auf der zweiten Seite in x-Richtung versehenen Piezo-Komposit,
- Fig. 11: eine Draufsicht auf ein mit Kontaktstreifen auf der zweiten Seite in x-Richtung versehenen Piezo-Komposit,
- Fig. 12: eine Draufsicht auf ein mit Kontaktstreifen auf der Ersten Seite in y-Richtung versehenen Piezo-Komposit,
- Fig. 13: eine Draufsicht auf ein mit Kontaktstreifen auf der ersten Seite und in y-Richtung einer strukturierten Gegenmassenplatte versehenen Piezo-Komposit,
- Fig. 14: eine Draufsicht auf ein mit Kontaktstreifen auf der zweiten Seite in x-Richtung und einer strukturierten Massenplatte versehenen Piezo-Komposit,
- Fig. 15: eine Draufsicht auf ein mit einem DUT auf der zweiten Seite versehenen Erregungselement,
- Fig. 16: einen Querschnitt durch ein mit strukturierter Masseplatte, strukturierter Gegenmasseplatte und DUT versehenen Piezo-Komposit und
- Fig. 17: eine perspektivische Darstellung eines Piezo-Komposit nach Fig. 16.

In Fig. 2 ist eine prinzipielle Anordnung eines DUT 3 auf einer Mess- und Kalibrieranordnung 2 dargestellt. Zu testen ist ein DUT (Device Under Test = DUT) 3, das auf einem Schwinger 4 angeordnet ist und durch diesen in mechanische Bewegungen in vertikaler oder "out-of-plane"-Richtung 5 versetzt wird. Der Schwinger 4 ist mit einer Gegenmasse 6 verbunden, die elastisch oder fest mit einer Grundmasse 7 verbunden sein kann.

Derartige DUT 3 bestehen aus einem oder mehreren Bewegungselementen 8 in Form von MEMS, die als Sensoren oder Aktoren ausgebildet sein können und einer Steuerelektronik, die auf einem Träger 9 (in der Form einer gedruckten Schaltung (Printed Circuit Board = PCB) oder einem Chip) angeordnet sind. Die Sensoren können beispielsweise Inertialsensoren (Beschleunigungs- und Drehsensoren) und die Aktoren beispielsweise optische Aktoren (z.B. Spiegelaktoren) fluidische Aktoren (z. Ventile oder Pumpen) oder akustische Aktoren (z.B. Schallerzeuger) darstellen.

Dieses Mikrosystem, bestehend aus Bewegungselementen 8 in Form von MEMS und dem Träger 9 in Form eines PCB ist auf einem Erregungselement 4 angeordnet. Das Erregungselement wird nach dem Stand der Technik als Schwinger ausgebildet, der in der Lage ist, das Mikrosystem 3 als DUT in translatorische Schwingungen zu versetzen, wonach die Reaktionen des DUT 3 auf die Schwingungen gemessen wird. Eine Messung von Aktionen eines DUT 3, d.h. wenn das DUT 3 einen Aktor als Bewegungselement 8 beinhaltet, ist mit einem solchen Aufbau nicht bekannt.

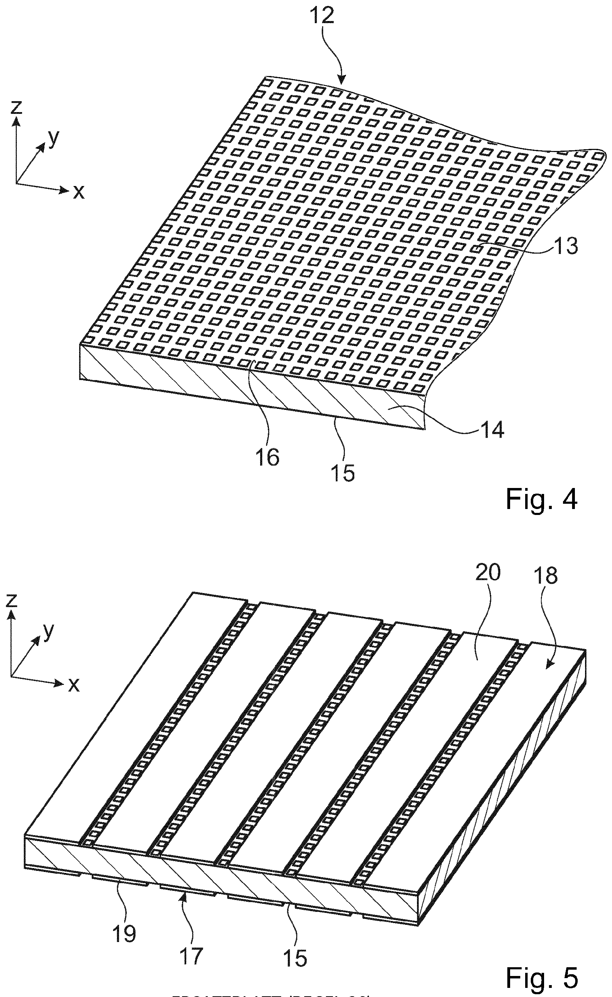

Ein Grundgedanke der Erfindung ist es, bei einem Erregungselement 4 gemäß Fig. 2 zur Erzeugung oder Messung von mechanischen Bewegungen als Erreger einen gemäß Fig. 3 und Fig. 4 an sich bekannten Piezo-Komposit 12 mit einer ersten Seite 15, einer mit einer Dicke d zur ersten Seite 15 beabstandeten zweiten Seite 16 und mit sich zwischen erster Seite 15 und zweiter Seite 16 erstreckenden stabförmigen Piezoelementen 13 als Erreger zu verwenden.

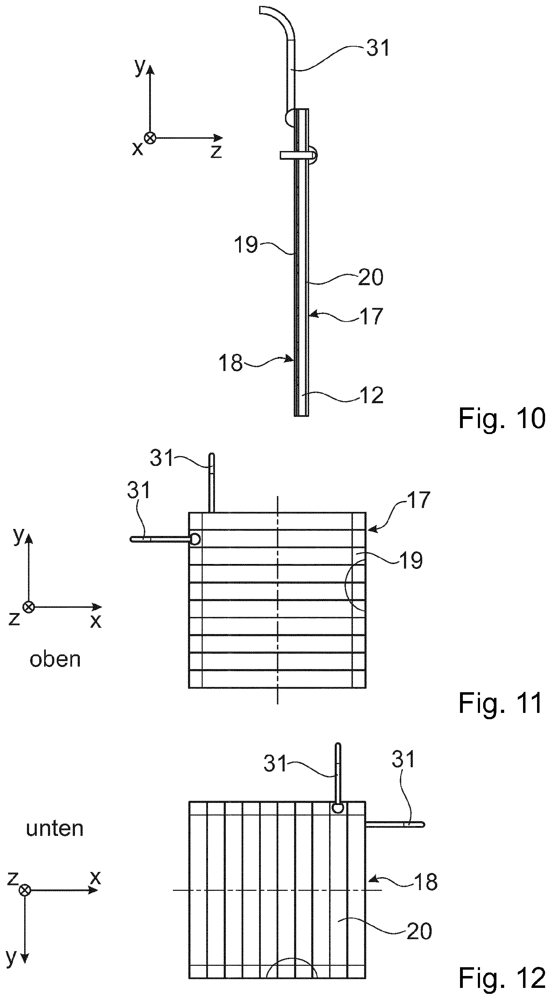

Wie in Fig. 5 dargestellt, ist der Piezo-Komposit 12 auf seiner ersten Seite 15 ist mit einer ersten segmentierten Kontaktfläche 17 und auf seiner zweiten Seiete 16 mit einer zweiten segmentierten Kontaktfläche 18 versehen, wobei die Kontaktflächen 17 und 18 über eine aus Kontakten 31, wie sie in den Fig. 10 bis 12 dargestellt sind, gebildete Schnittstelle segmentweise und getrennt voneinander ansteuerbar sind.

Beide Kontaktflächen 17 und 18 sind streifenförmig segmentiert, jeweils in Kontaktstreifen 19 der ersten Kontaktfläche 17 und Kontaktstreifen 20 der zweiten Kontaktfläche 18, wobei jeder der Kontaktstreifen 19 und 20 vorzugsweise aber nicht zwingend die gleiche Breite aufweist.

Nun gibt es zwei Möglichkeiten der Ausrichtung der Kontaktstreifen 19 und 20.

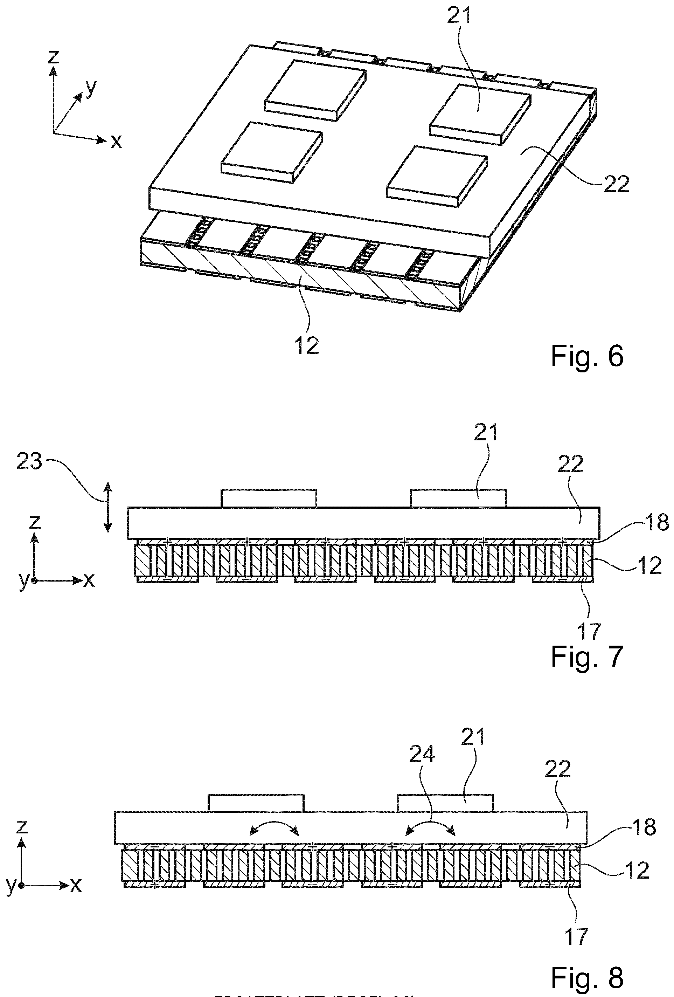

Wie in Fig. 6 dargestellt, kann das mit den Kontaktflächen 17 und 18 versehene Piezoelement 13 mit einem DUT 3 vorzugsweise ein PCB mit einem MEMS bestückt werden. In dem Beispiel enthält das DUT 3 vier MEMS 21 die auf einem PCB 22 angeordnet sind.

Die Kontaktstreifen 19 und 20 der beiden Kontaktflächen 17 und 18 können dieselbe Ausrichtung in horizontaler, d.h. in **x-** oder y-Richtung aufweisen.

In Fig. 7 ist dargestellt, dass mit dem Anlegen einer gleichen Spannung an die erste Kontaktfläche 17 und einer anders gepolten Spannung an die zweite Kontaktfläche 18 eine translatorische Bewegung 23 erzeugt werden kann.

In Fig. 8 ist dargestellt, dass mit dem Anlegen einer unterschiedlichen Spannung an die erste Kontaktfläche 17 und einer anders gepolten unterschiedlichen Spannung an die zweite Kontaktfläche 18 eine rotatorische Bewegung 24 erzeugt werden kann.

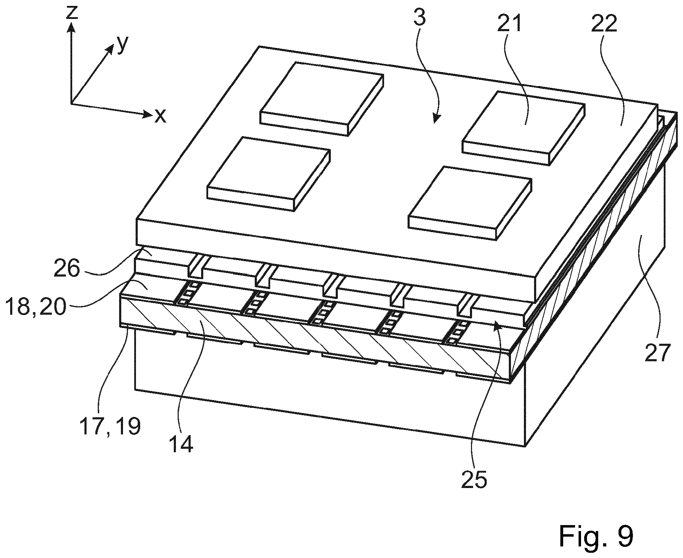

Wie in Fig. 9 dargestellt, ist der Piezo-Komposit 12 als Ausführungsform des Erregers über der zweiten Kontaktfläche 18 mit einer segmentierten Koppelplatte 25 versehen.

Diese segmentierte Koppelplatte 25 stellt eine Aufnahme für das DUT 3 dar.

Die Koppelplatte 25 ist in streifenförmige erste Koppelplattensegmente 26 segmentiert, derart, dass deren Breite und Richtung den Kontaktstreifen 20 der zweiten Kontaktfläche 18 entsprechen und die ersten Koppelplattensegmente 26 in y-Richtung ausgerichtet sind und in vertikaler z-Richtung über den Kontaktstreifen 20 der zweiten Kontaktfläche 18 liegen.

Der Piezo-Komposit 12 ist an seiner ersten Seite mit einer Gegenmasse 27 verbunden.

Wie in den Fig. 10 bis Fig. 12 dargestellt, können in einer anderen Ausführungsform die Kontaktstreifen 19 auf der ersten Kontaktfläche 17 eine Ausrichtung in einer ersten horizontalen, d.h. x-Richtung, und auf der zweiten Kontaktfläche 18 in einer orthogonal zur ersten horizontalen zweiten Richtung, d.h. y-Richtung, liegenden Richtung aufweisen. In den Figuren sind die Kontakte 31 nur schematisch dargestellt. Üblicherweise werden alle Kontaktstreifen 19 und 20 mit Kontakten 31 versehen. Nicht dargestellt aber möglich sind auch schräge Ausführungsformen oder ringförmige oder andere Formen der Kontaktstreifen.

Damit können mit dem Anlegen einer Spannung die Piezoelemente 13 in den sich kreuzenden Bereichen der Kontaktstreifen 19 und 20 jeweils gezielt angeregt oder gemessen werden, analog zu der Spannungsbeaufschlagung in den Fig. 7 und Fig. 8.

Die Koppelplatte 25 kann unter Entstehung von quadratischen zweiten Koppelplattensegmenten 28 zusätzlich in in x-Richtung verlaufende Streifen segmentiert werden, und die quadratischen zweiten Koppelplattensegmente 28 bei einer Ausrichtung der Kontaktstreifen 19 und 20 der ersten und der zweiten Kontaktfläche 17 und 18 orthogonal zueinander in vertikaler z-Richtung über in einer Projektion in vertikaler z-Richtung gesehenen Schnittflächen der Kontaktstreifen 19 und 20 der ersten und der zweiten Kontaktfläche 17 und 18 liegen.

Die ersten oder zweiten Koppelplattensegmente 26, 28 sind jeweils benachbart miteinander mittels eines Verbindungsmittels mechanisch verbunden, wobei das Elastizitätsmodul des Verbindungsmittels kleiner als das der Koppelplattensegmente ist. Das Verbindungsmittel kann aus Epoxy oder Silikon bestehen. Weiterhin kann durch entsprechende Formgebung auch eine Entkopplung erreicht werden, beispielsweise durch einen schmalen Steg, wie in mit Bezugszeichen 26 in Fig. 9 dargestellt.

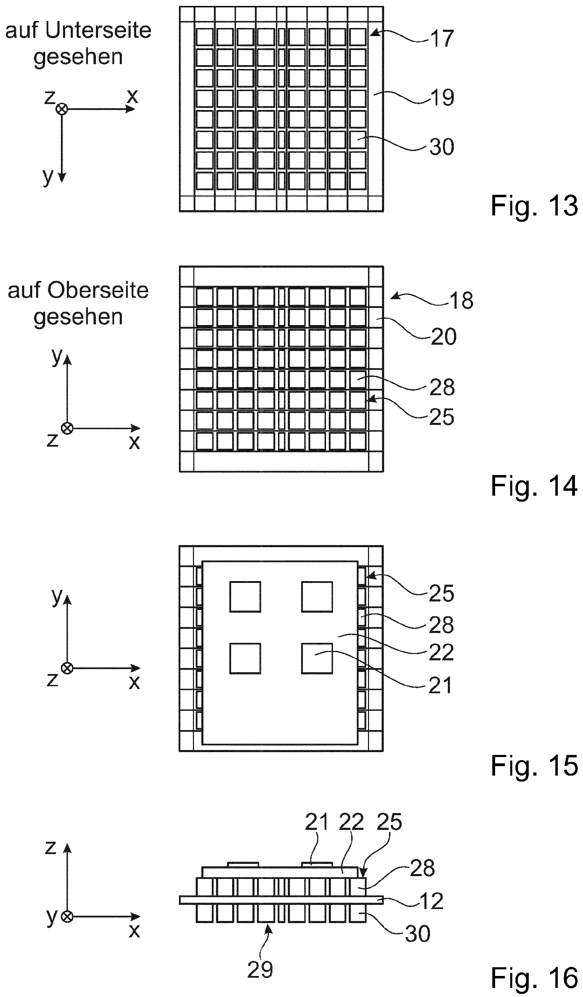

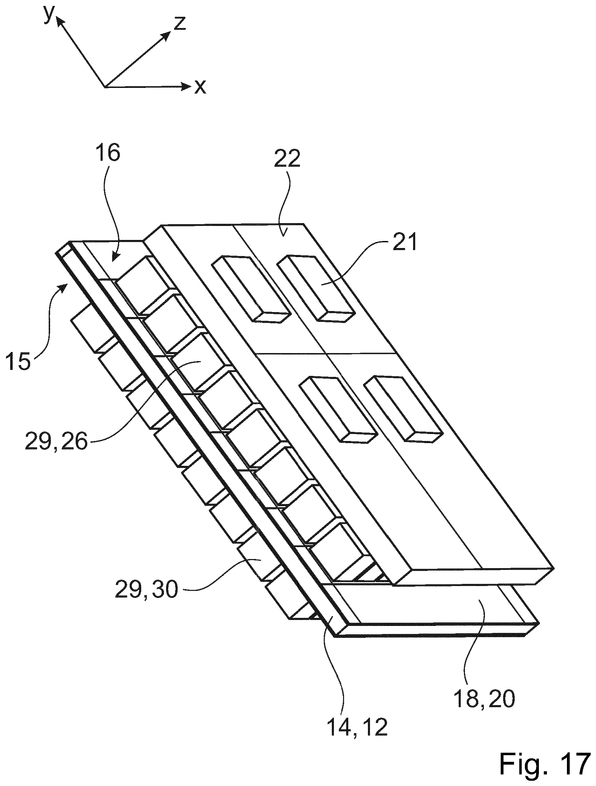

Wie in Fig. 13 und Fig. 17 dargestellt, ist die Gegenmasse 27 als segmentierte Gegenmassenplatte 29 ausgebildet, die korrespondierend zu der Koppelplatte 25 in Gegenmassesegmente 30 strukturiert ist.

Erzeugt wird dies indem die Koppelplatte 25 und/oder Gegenmassenplatte 29 mit einem Abstand und einer Richtung, die denen der Koppelplattensegmente 26 bzw. Der Gegenmassenelemente 30 entsprechen, von ihrer ersten oder zweiten Seite mit einem Einschnitt versehen wird, wobei der Einschnitt jedoch nicht bis zu der jeweiligen anderen zweiten oder ersten Seite sondern nur bis zu einem Abstand zu der gegenseitigen ersten oder zweiten Seite reicht, dass der Einschnitt mit einem Verbindungsmittel gefüllt wird und die Koppelplatte 25 bzw. die Gegenmassenplatte 29 auf der jeweils gegenseitigen ersten oder zweiten Seite bis zum Erreichen des Einschnittes abgetragen wird.

### Bezugszeichenliste

0.1 Schwingungserreger
0.2 Gehäuse
0.3 Grundplatte
0.4 Schwinger
0.5 Gegenmasse
0.6 DUT-Aufnahme
1 Piezoschwinger
1a Piezoschwingplatte
2 Mess- oder Kalibrieranordnung
3 Mikrosystem, DUT
4 Erregungselement, Schwinger
5 "out-of-plane"- Richtung
6 Gegenmasse
7 Grundmasse
8 Bewegungselement, MEMS
9 Träger, PCB
10 "in-plane"-Bewegung
11 Bewegungsachse
12 Piezo-Komposit
13 Piezoelement
14 Matrix
15 erste Seite
16 zweite Seite
17 erste segmentierten Kontaktfläche auf der ersten Seite
18 zweite segmentierten Kontaktfläche auf der zweiten Seite
19 Kontaktstreifen der ersten Kontaktfläche
20 Kontaktstreifen der zweiten Kontaktfläche
21 MEMS
22 PCB
23 translatorische Bewegung
24 rotatorische Bewegung
25 segmentierte Koppelplatte
26 streifenförmiges erstes Koppelplattensegment
27 Gegenmasse
28 quadratisches zweites Koppelplattensegment
29 segmentierte Gegenmassenplatte
30 Gegenmassesegment
31 Kontakt

## Patentansprüche

1. Erregungselement zur Erzeugung von mechanischen Bewegungen mit einem Erreger und einer Aufnahme für ein zu testendes Objekt sowie mit einer elektrischen Schnittstelle zur Übermittlung der Erregungs- oder Messdaten, wobei
- eine an sich bekannte Piezoschwingplatte (1a) oder ein Piezoschwinger (1) in Form eines Piezo-Komposits (12) mit einer in Richtung der Plattendicke (d) quer liegenden ersten Seite (15), einer mit der Plattendicke beabstandeten und parallel zur ersten Seite liegenden zweiten Seite und mit Piezoelementen zwischen erster und zweiter Seite verwendet wird,
- der Erreger auf seiner ersten Seite (15) mit einer ersten Kontaktfläche (17) und auf seiner zweiten Seite (16) mit einer zweiten Kontaktfläche (18) versehen ist, wobei die Kontaktflächen (17; 18) ansteuerbar sind, **dadurch gekennzeichnet**,
-dass der Erreger auf seiner zweiten Seite (16) ein zu testendes Objekt (3) aufnehmend gestaltet ist, wobei der Erreger über der zweiten Kontaktfläche (18) mit einer segmentierten Koppelplatte (25) versehen ist.

2. Erregungselement nach Anspruch 1, **dadurch gekennzeichnet, dass** ein an sich bekannter plattenförmiger Piezo-Komposit (12) mit einer in Richtung der Plattendicke (d) quer liegenden ersten Seite (15), einer mit der Plattendicke (d) beabstandeten und parallel zur ersten Seite (15) liegenden zweiten Seite (16) und mit sich zwischen erster (15) und zweiter Seite (16) erstreckenden stabförmigen Piezoelementen (13) als Erreger verwendet wird und der Erreger in Segmente aus Piezoelementen (13) gegliedert ist, die separat erregbar gestaltet sind.

3. Erregungselement nach Anspruch 2, **dadurch gekennzeichnet, dass** der Erreger auf seiner ersten Seite (15) mit einer ersten segmentierten Kontaktfläche (17) und auf seiner zweiten Seite (16) mit einer zweiten segmentierten Kontaktfläche (18) versehen ist, wobei die Kontaktflächen (17; 18) über die Schnittstelle segmentweise und getrennt voneinander ansteuerbar sind.

4. Erregungselement nach einem der Ansprüche 1 bis 3, **dadurch gekennzeichnet, dass** beide Kontaktflächen (17; 18) streifenförmig segmentiert sind, wobei jeder Kontaktstreifen (19; 20) die gleiche Breite aufweist.

5. Erregungselement nach einem der Ansprüche 1 bis 4, **dadurch gekennzeichnet, dass** die Kontaktstreifen (19; 20) der beiden Kontaktflächen (17; 18) dieselbe Ausrichtung in horizontaler, d.h. in x- oder y-Richtung aufweisen.

6. Erregungselement nach einem der Ansprüche 1 bis 4, **dadurch gekennzeichnet, dass** die Kontaktstreifen (19) auf der ersten Kontaktfläche (17) eine Ausrichtung in einer ersten horizontalen, d.h. x-Richtung, und die Kontaktstreifen (20) auf der zweiten Kontaktfläche (18) in einer orthogonal zur ersten horizontalen zweiten Richtung, d.h. y-Richtung, liegenden Richtung aufweisen.

7. Erregungselement nach Anspruch 1 bis 6, **dadurch gekennzeichnet, dass** die Koppelplatte (25) in streifenförmige erste Koppelplattensegmente (26) segmentiert ist, derart, dass deren Breite und Richtung den Kontaktstreifen (20) der zweiten Kontaktfläche (18) entsprechen und die ersten Koppelplattensegmente in y-Richtung ausgerichtet sind und in vertikaler z-Richtung über den Kontaktstreifen (20) der zweiten Kontaktfläche (18) liegen.

8. Erregungselement nach Anspruch 7, d**adurch gekennzeichnet, dass** die Koppelplatte (25) unter Entstehung von quadratischen zweiten Koppelplattensegmenten (28) zusätzlich in in x-Richtung verlaufende Streifen segmentiert ist, und die quadratischen zweiten Koppelplattensegmente (28) bei einer Ausrichtung der Kontaktstreifen (19; 20) der ersten und der zweiten Kontaktfläche (17; 18) orthogonal zueinander in vertikaler z-Richtung über in einer Projektion in vertikaler z-Richtung gesehenen Schnittflächen der Kontaktstreifen (19; 20) der ersten und der zweiten Kontaktfläche (17; 18) liegen.

9. Erregungselement nach einem der Ansprüche 7 oder 8, **dadurch gekennzeichnet, dass** die ersten (26) oder zweiten Koppelplattensegmente (28) jeweils benachbart miteinander mittels eines Verbindungsmittels mechanisch verbunden sind, wobei das Elastizitätsmodul des Verbindungsmittels kleiner als das der Koppelplattensegmente (26; 28) ist.

10. Erregungselement nach Anspruch 9, **dadurch gekennzeichnet, dass** das Verbindungsmittel aus Epoxydharz, Silikon oder einem anderen Kunststoff besteht.

11. Erregungselement nach einem der Ansprüche 6 bis 10, **dadurch gekennzeichnet, dass** der Erreger an seiner ersten Seite (15) mit einer Gegenmasse (6) verbunden ist.

12. Erregungselement nach Anspruch 11, **dadurch gekennzeichnet, dass** die Gegenmasse (6; 27) als Gegenmassenplatte (29) ausgebildet ist, die korrespondierend zu der Koppelplatte (25) in Gegenmassesegmente (30) strukturiert ist.

13. Erregungselement nach einem der Ansprüche 1 bis 12, **dadurch gekennzeichnet, dass** das Erregungselement auf einem zweiten Schwingungserreger (0.1) befestigt ist.

14. Verfahren zur Herstellung eines Erregungselements nach einem der Ansprüche 9 oder 10, **dadurch gekennzeichnet, dass** die Koppelplatte (25) mit einem Abstand und einer Richtung, die denen der Koppelplattensegmente (26; 28) entsprechen, von ihrer zweiten (16) oder ersten Seite (15) mit einem Einschnitt versehen wird, wobei der Einschnitt jedoch nicht bis zu der jeweiligen anderen zweiten (16) oder ersten Seite (15) sondern nur bis zu einem Abstand zu der gegenseitigen ersten (15) oder zweiten Seite (16) reicht, dass der Einschnitt mit dem Verbindungsmittel gefüllt wird und die Koppelplatte (25) auf der jeweils gegenseitigen ersten (15) oder zweiten Seite (16) bis zum Erreichen des Einschnittes abgetragen wird.

15. Verfahren nach Anspruch 14, **dadurch gekennzeichnet, dass** die Koppelplatte (25) mit dem Erreger verbunden wird, derart, dass einem Koppelplattensegment (26; 28) mehrere Erregerelemente (13) gegenüberstehen.

16. Verfahren nach einem der Ansprüche 14 bis 15, **dadurch gekennzeichnet, dass** der Erreger mit der Gegenmassenplatte (29) verbunden und die Gegenmassenplatte (29) in der Art der Koppelplatte (25) strukturiert wird.

## Claims

1. Excitation element for generating mechanical movements, comprising an exciter and a receptacle for an object to be tested, and comprising an electrical interface for transmitting excitation or measurement data,
- a piezoelectric oscillation plate (1a), known per se, or a piezoelectric oscillator (1) in the form of a piezoelectric composite (12) being used which comprises a first face (15) lying transversely in the direction of the plate thickness (d), a second face spaced by the plate thickness and lying parallel to the first face and which comprises piezoelectric elements between the first and second face,
- the exciter being provided with a first contact surface (17) on the first face (15) thereof and being provided with a second contact surface (18) on the second face (16) thereof, the contact surfaces (17; 18) being controllable,
**characterized in that** the exciter is designed to receive an object (3) to be tested on the second face (16) thereof, the exciter being provided with a segmented coupling plate (25) over the second contact surface (18).

2. Excitation element according to claim 1, **characterized in that** a planar piezoelectric composite (12), known per se, comprising a first face (15) lying transversely in the direction of the plate thickness (d), a second face (16) spaced apart by the plate thickness (d) and lying parallel to the first face (15), and comprising rod-shaped piezoelectric elements (13) extending between the first face (15) and the second face (16), is used as the exciter and the exciter is divided into segments of piezoelectric elements (13) which are designed to be separately excitable.

3. Excitation element according to claim 2, **characterized in that** the exciter is provided with a first segmented contact surface (17) on the first face (15) thereof and is provided with a second segmented contact surface (18) on the second face (16) thereof, the contact surfaces (17; 18) being controllable segmentally and separately from one another via the interface.

4. Excitation element according to any of claims 1 to 3,
**characterized in that** both contact surfaces (17; 18) are segmented into strips, each contact strip (19; 20) being the same width.

5. Excitation element according to any of claims 1 to 4,
**characterized in that** the contact strips (19; 20) of the two contact surfaces (17; 18) have the same orientation in the horizontal direction, i.e. in the x or y direction.

6. Excitation element according to any of claims 1 to 4,
**characterized in that** the contact strips (19) on the first contact surface (17) have an orientation in a first horizontal, i.e. x direction, and the contact strips (20) on the second contact surface (18) have a direction in a direction orthogonal to the first horizontal second direction, i.e. y direction.

7. Excitation element according to claim 1 to 6, **characterized in that** the coupling plate (25) is segmented into strip-shaped first coupling plate segments (26) such that the width and direction of the coupling plate segments correspond to the contact strips (20) of the second contact surface (18) and the first coupling plate segments are oriented in the y direction and lie in the vertical z direction over the contact strips (20) of the second contact surface (18).

8. Excitation element according to claim 7, **characterized in that** the coupling plate (25) is additionally segmented into strips extending in the x direction, forming square second coupling plate segments (28), and the square second coupling plate segments (28) lie over sectional surfaces of the contact strips (19; 20) of the first and the second contact surface (17; 18) viewed in a projection in the vertical z direction, when the contact strips (19; 20) of the first and the second contact surface (17; 18) are orientated orthogonally to one another in a vertical z direction.

9. Excitation element according to either of claims 7 or 8,
**characterized in that** the first coupling plate segments (26) or the second coupling plate segments (28) are each mechanically joined adjacent to one another by means of a joining means, the modulus of elasticity of the joining means being smaller than the modulus of elasticity of the coupling plate segments (26; 28).

10. Excitation element according to claim 9, **characterized in that** the joining means consists of epoxy resin, silicone or another plastics material.

11. Excitation element according to any of claims 6 to 10, **characterized in that** the exciter is joined at the first face thereof (15) to a countermass (6).

12. Excitation element according to claim 11, **characterized in that** the countermass (6; 27) is designed as a countermass plate (29) which is structured into countermass segments (30) corresponding to the coupling plate (25).

13. Excitation element according to any of claims 1 to 12, **characterized in that** the excitation element is attached to a second vibration exciter (0.1).

14. Method for manufacturing an excitation element according to either of claims 9 or 10, **characterized in that** the coupling plate (25) is provided with a recess from the second face (16) or the first face (15) thereof at a distance and in a direction which correspond to those of the coupling plate segments (26; 28), the recess, however, not reaching to the relevant other second face (16) or first face (15) but only to a distance from the opposing first (15) or second face (16), and **in that** the recess is filled with the joining means, and the coupling plate (25) on the relevant opposing first face (15) or second face (16) is removed until the recess is reached.

15. Method according to claim 14, **characterized in that** the coupling plate (25) is joined to the exciter such that a plurality of exciter elements (13) are opposite a coupling plate segment (26; 28).

16. Method according to any of claims 14 to 15, **characterized in that** the exciter is joined to the countermass plate (29) and the countermass plate (29) is structured in the form of the coupling plate (25).

## Revendications

1. Élément d'excitation permettant de générer des mouvements mécaniques, comportant un excitateur et un élément de réception pour un objet à tester, et comportant une interface électrique pour la transmission des données d'excitation ou de mesure, dans lequel
- une plaque d'oscillation piézoélectrique (1a) connue en soi ou un oscillateur piézoélectrique (1) sous forme de composite piézoélectrique (12), comportant un premier côté (15) placé transversalement en direction de l'épaisseur de plaque (d), un second côté espacé de l'épaisseur de plaque et placé parallèlement au premier côté, et comportant des éléments piézoélectriques entre le premier et le second côté, est utilisé,
- l'excitateur est pourvu, sur son premier côté (15), d'une première surface de contact (17) et, sur son second côté (16), d'une seconde surface de contact (18), dans lequel les surfaces de contact (17 ; 18) peuvent être commandées, **caractérisé en ce que** l'excitateur est conçu pour recevoir, sur son second côté (16), un objet à tester (3), dans lequel l'excitateur est pourvu, au-dessus de la seconde surface de contact (18), d'une plaque de couplage segmentée (25).

2. Élément d'excitation selon la revendication 1, **caractérisé en ce qu'un** composite piézoélectrique (12) en forme de plaque connu en soi, comportant un premier côté (15) placé transversalement en direction de l'épaisseur de plaque (d), un second côté (16) espacé de l'épaisseur de plaque (d) et placé parallèlement au premier côté (15), et comportant des éléments piézoélectriques (13) en forme de tige s'étendant entre le premier (15) et le second côté (16), est utilisé comme excitateur et l'excitateur est divisé en segments d'éléments piézoélectriques (13) qui sont configurés de manière à pouvoir être excités séparément.

3. Élément d'excitation selon la revendication 2, **caractérisé en ce que** l'excitateur est pourvu, sur son premier côté (15), d'une première surface de contact segmentée (17) et, sur son second côté (16), d'une seconde surface de contact segmentée (18), dans lequel les surfaces de contact (17 ; 18) peuvent être commandées dans certains segments et séparément les unes des autres par l'intermédiaire de l'interface.

4. Élément d'excitation selon l'une des revendications 1 à 3,
**caractérisé en ce que** les deux surfaces de contact (17 ; 18) sont segmentées en bandes, dans lequel chaque bande de contact (19 ; 20) présente la même largeur.

5. Élément d'excitation selon l'une des revendications 1 à 4,
**caractérisé en ce que** les bandes de contact (19 ; 20) des deux surfaces de contact (17 ; 18) présentent la même orientation dans la direction horizontale, c'est-à-dire dans la direction x ou y.

6. Élément d'excitation selon l'une des revendications 1 à 4,
**caractérisé en ce que** les bandes de contact (19) sur la première surface de contact (17) présentent une orientation dans une première direction horizontale, c'est-à-dire la direction x, et les bandes de contact (20) sur la seconde surface de contact (18) présentent une orientation dans une direction orthogonale à la première direction horizontale, c'est-à-dire la direction y.

7. Élément d'excitation selon les revendications 1 à 6,
**caractérisé en ce que** la plaque de couplage (25) est segmentée en premiers segments de plaque de couplage en bandes (26), de telle sorte que leur largeur et leur direction correspondent aux bandes de contact (20) de la seconde surface de contact (18) et que les premiers segments de plaque de couplage sont orientés dans la direction y et se trouvent au-dessus des bandes de contact (20) de la seconde surface de contact (18) dans la direction verticale z.

8. Élément d'excitation selon la revendication 7, **caractérisé en ce que** la plaque de couplage (25) est en outre segmentée en bandes s'étendant dans la direction x pour créer de seconds segments de plaque de couplage carrés (28), et les seconds segments de plaque de couplage carrés (28) sont placés, lorsque les bandes de contact (19 ; 20) de la première et de la seconde surface de contact (17 ; 18) sont orientées de manière à être orthogonales les unes par rapport aux autres dans la direction verticale z, au-dessus des surfaces d'intersection des bandes de contact (19 ; 20) de la première et de la seconde surface de contact (17 ; 18), vues en projection dans la direction verticale z.

9. Élément d'excitation selon l'une des revendications 7 ou 8,
**caractérisé en ce que** les premiers (26) ou seconds segments de plaque de couplage (28) sont respectivement reliés mécaniquement de manière à être adjacents les uns aux autres au moyen d'un moyen de liaison, dans lequel le module d'élasticité du moyen de liaison est plus petit que celui des segments de plaque de couplage (26 ; 28).

10. Élément d'excitation selon la revendication 9, **caractérisé en ce que** le moyen de liaison est constitué de résine époxy, de silicone ou d'une autre matière plastique.

11. Élément d'excitation selon l'une des revendications 6 à 10,
**caractérisé en ce que** l'excitateur est relié, sur son premier côté (15), à une contre-masse (6).

12. Élément d'excitation selon la revendication 11, **caractérisé en ce que** la contre-masse (6 ; 27) est réalisée sous forme de plaque de contre-masse (29) qui est structurée en segments de contre-masse (30) correspondant à la plaque de couplage (25).

13. Élément d'excitation selon l'une des revendications 1 à 12,
**caractérisé en ce que** l'élément d'excitation est fixé à un second oscillateur (0.1).

14. Procédé de fabrication d'un élément d'excitation selon l'une des revendications 9 ou 10, **caractérisé en ce que** la plaque de couplage (25) est pourvue d'une encoche sur son second (16) ou son premier côté (15), à une certaine distance et dans une direction correspondant à celles des segments de plaque de couplage (26 ; 28), dans lequel l'encoche ne s'étend toutefois pas jusqu'à l'autre second (16) ou premier côté (15) respectif, mais seulement jusqu'à une certaine distance par rapport au premier (15) ou second côté (16) opposé, de sorte que l'encoche est remplie avec le moyen de liaison et la plaque de couplage (25) est usinée sur le premier (15) ou le second côté (16) opposé respectif jusqu'à atteindre l'encoche.

15. Procédé selon la revendication 14, **caractérisé en ce que** la plaque de couplage (25) est connectée à l'excitateur de telle sorte que plusieurs éléments d'excitation (13) se trouvent en face d'un segment de plaque de couplage (26 ; 28).

16. Procédé selon l'une des revendications 14 à 15, **caractérisé en ce que** l'excitateur est relié à la plaque de contre-masse (29) et la plaque de contre-masse (29) est structurée à la manière de la plaque de couplage (25).
